Europäisches Patentamt

(19) European Patent Office

Office européen des brevets

(11) Veröffentlichungsnummer: **0 001 123**
**B1**

(12) **EUROPÄISCHE PATENTSCHRIFT**

(45) Veröffentlichungstag der Patentschrift: **16.06.82**

(51) Int. Cl.³: **H 01 L 23/42,**
**H 01 L 23/44, H 01 L 23/46**

(21) Anmeldenummer: **78100863.6**

(22) Anmeldetag: **09.09.78**

(54) Kapselanordnung zum Kühlen von Halbleiterchips.

(30) Priorität: **12.09.77 US 832716**

(43) Veröffentlichungstag der Anmeldung:
**21.03.79 Patentblatt 79/6**

(45) Bekanntmachung des Hinweises auf die Patenterteilung:
**16.06.82 Patentblatt 82/24**

(84) Benannte Vertragsstaaten:
**DE FR GB**

(56) Entgegenhaltungen:
**US - A - 3 993 123**

**NACHRICHTENTECHNISCHE ZEITSCHRIFT,
Band 27, Oktober 1974
Berlin
"Neue Kühlung in der Elektronik", Seiten
243—244**

**IBM TECHNICAL DISCLOSURE BULLETIN, Band
17, April 1975,
New York
H. PARSAPOUR: "Modular heat-sink", Seite
3313**

(73) Patentinhaber: **International Business Machines
Corporation
Armonk, N.Y. 10504 (US)**

(72) Erfinder: **Meeker, Robert Glen
Clapp Hill Road
Lagrangeville, NY 12540 (US)**
Erfinder: **Scanlon, William Joseph
27 Candy Lane
Hopewell Junction, NY 12533 (US)**
Erfinder: **Segal, Zvi
12 Plaza Road
Wappingers Falls, NY 12590 (US)**

(74) Vertreter: **Blutke, Klaus, Dipl.-Ing.
Schönaicher Strasse 220
D-7030 Böblingen (DE)**

(56) Entgegenhaltungen:

**IBM TECHNICAL DISCLOSURE BULLETIN, Band 19, Mai 1977,**
**New York**
**H. C. KAMMERER: "Thermal conduction button", Seiten 4622—4623**

**IBM TECHNICAL DISCLOSURE BULLETIN, Band 20, März 1978,**
**New York**
**A. L. PASCUZZO et al.: "Integrated circuit module package cooling structure", Seiten 3898—3899**

## Kapselanordnung zum Kühlen von Halbleiterchips

Die Erfindung betrifft eine Kapselanordnung zum Kühlen von Halbleiterchips.

Mit dem Fortschritt der Festkörperelektronik wurden verschiedene verbesserte Einrichtungen zum Ableiten der durch die Festkörperkomponenten erzeugten Wärme untersucht. Bei dem Standardkühlverfahren mit Druckluft treten durch begrenzte Wärmeableitflächen Störprobleme auf, so daß ohne irgendeine technische Hilfe nicht jedes der zahlreichen Bauteile, wie sie auf integrierten Halbleiterchips zu finden sind, im richtigen Betriebstemperaturbereich zu halten ist.

Daher wurden insbesondere in Verbindung mit sehr schnellen Datenverarbeitungssystemen kombinierte Luft-Flüssigkeits-Kühlsystemen entwickelt. In einem solchen Kühlsystem werden die zu kühlenden Komponenten in einen Tank mit Kühlflüssigkeit eingetaucht. Als Kühlflüssigkeit werden wegen ihres niedrigen Siedepunktes häufig Fluorkohlenstoffe verwendet. In Anbetracht der Probleme bei der Wartung und Packung von in dieser Tauchtechnik gekühlten Komponenten wurde eine gekapselte Kühltechnik entwickelt, bei der dasselbe dielektrische Material für jedes Modul separat verwendet wird.

In der US Patentschrift 3 741 292 ist als Beispiel ein Modul gezeigt, dessen wärmeerzeugende Komponenten von einer dielektrischen Flüssigkeit mit niedrigem Siedepunkt umgeben sind und mit dieser Flüssigkeit gekapselt sind. Über dem Flüssigkeitsspiegel liegt ein Verdampfungsraum mit Finnen, die in den Behälter hineinragen, der als Kondensator für die Dämpfe der dielektrischen Flüssigkeit dient. Nach außen reichende Finnen oder Kühlrippen des Behälters dienen als luftgekühlte Wärmeableiter für die internen Kühlrippen. Ein solches Modul mit gekapseltem Kühlelement weist jedoch eine gewisse Inflexibilität auf. So muß z.B. das Kühlmittel von extremer Reinheit und frei von allen Verunreinigungen sein. Der Betrieb ist empfindlich für alle Variablen, die den Grundprozeß des Siedens an einzelnen Punkten und der Dampfkondensation betreffen. Außerdem läßt sich das Konzept nicht ohne weiteres auf kleine Teile anwenden, wie etwa auf wärmeerzeugende Komponenten oder Halbleiterchips.

Aus der US-Patentschrift 3 993 123 ist eine Kapselanordnung zum Kühlen von Halbleiterchips bekannt mit einem Wärmeabführelement in engem Kontakt zum Halbleiterchip, mit einem federnden, balgförmigen Element, dessen chipfernes Ende in einer Aussparung eines wärmeleitenden Teiles der Kapselanordnung fixiert ist und mit einem Kühlmedium innerhalb und außerhalb des balgförmigen Elementes.

In der US-Patentschrift 3 512 582 wird ein Tauchkühlsystem für modulargepackte Komponenten (wie Halbleiterchips) beschrieben, das ein gemeinsames Gefäß mit einer Flüssigkeit mit niedrigem Siedepunkt enthält. Mehrere modulare Einheiten, die jeweils eine einzelne Kühlkammer enthalten, sind mit dem gemeinsamen Gefäß über entsprechende Eingangs- und Ausgangsleitungen verbunden. Die einzelnen Kühlkammern und die Eingangsleitungen sind so angeordnet, daß die Flüssigkeit von dem gemeinsamen Gefäß per Schwerkraft durch die Eingangsleitungen in die einzelnen Kühlkammern fließt. Die Ausgangsleitungen bilden die Flüssigkeits-Expansionsbahn für die einzelnen Kühlkammern. Die wärmeerzeugenden Komponenten liegen in jeder Kühlkammer in Wärmeaustauschkontakt mit der niedrigsiedenden Flüssigkeit und werden auf diese Weise gekühlt. Zu jeder Kühlkammer gehört ein Wärmetauscher zur Entfernung der Wärme aus der niedrigsiedenden Flüssigkeit, so daß besagte elektronische Komponenten ausreichend gekühlt und im wesentlichen auf einer vorgegebenen Temperatur gehalten werden.

In der US Patentschrift 3 524 497 sind elektronische Komponenten wie Halbleiterchips oder dergleichen beschrieben, die an einem Ende von wärmeleitenden Kühlzapfen sitzen. Die die Halbleiter tragenden Enden der Kühlzapfen sind an einer Seite mit einer Schaltkarte verbunden. Die Schaltkarte bildet eine Wand eines engen Kanals, durch den Flüssigkeit unter Druck fließt. Die Zapfen verlaufen von der Wand in den Kanal hinein in einem bestimmten Abstand zueinander. Andere mit der gegenüberliegenden Wand verbundene Zapfen laufen ebenfalls zu den Kühlzapfen und in einem bestimmten Abstand gestaffelt parallel dazu in den Kanal hinein. Zusätzliche Zapfen sorgen für eine stärkere Turbulenz der Kühlflüssigkeit um die Wärmeleitzapfen und richten den Strom der Kühlflüssigkeit über eine größere Fläche der Kühlzapfen und vergrößern so die Wärmeübertragung.

In der US Patentschrift 3 586 101 wird ein Flüssigkeitskühlsystem für Datenverarbeitungsanlagen beschrieben, in dem mehrere elektronische Komponentenmodule zu kühlen sind, die in Kammern liegen, in denen eine Kühlflüssigkeit durch die Schwerkraft umläuft. Der Zufluß der Kühlflüssigkeit erfolgt von einem Pufferspeicherbehälter her, der oben im Kühlsystem liegt. Eine Phasentrennsäule ist vorgesehen, die mit dem Ausgang einer jeden Modulkammer durch Leitungen gleicher Länge verbunden ist. Die Komponenten innerhalb der Module bringen die Kühlflüssigkeit stellenweise zum Sieden. Die Dampfblasen und die Kühlflüssigkeit laufen durch die Leitungen und wieder in die Phasentrennsäule hinein, wo die Dampfblasen aufsteigen und die Kühlflüssigkeit abtropft. Über der Phasentrennsäule liegt ein Kondensator zur Kondensation der Dampfblasen. Das Kondensat und die Flüssigkeit in der Phasentrennsäule werden in das Umlaufsystem zurückgeführt. Im Umlaufsystem liegt eine Kühleinrichtung, um die Kühlflüssigkeit auf eine Temperatur unterhalb des Siedepunkte herunterzukühlen.

In der US-Patentschrift Nr. 3 673 306 wird die Verwendung eines Wärmeleitrohres in einem Metallgehäuse wie in einem Transistorbehälter gezeigt, um Hochleistungshalbleiter zu kühlen, die normalerweise eine große Wärmeverlustleistung haben. Es ist ein elektrisch nicht leitender Docht vorgesehen, der z.B. aus hochgradig reiner Siliciumglaswolle besteht und ein Futter für den ganzen Transistorbehälter bildet. Der Docht berührt die aktive Oberfläche des Halbleiters unten am Behälter und die oberen Wände. Bevor der Behälter auf seine Montagebasis eingesetzt wird, wird eine angemessene Menge elektrisch nicht leitender und nicht polarwirkender Flüssigkeit — wie eine hochgradig reine organische Flüssigkeit — eingefüllt, so daß der Docht ganz gefüllt oder gesättigt ist. Die im Docht festgehaltene Arbeitsflüssigkeit steht somit in direktem Kontakt mit der aktiven Oberfläche des Halbleiters, die im Betrieb als Verdampferteil der geschlossenen Wärmeleitschleife wirkt. Wenn Flüssigkeit aus diesem Bereich verdampft, findet eine Wärmeübertragung und somit eine Kühlung des Elementes statt. Der so erzeugte Dampf wird über entsprechenden Bereichen des Behälters wieder kondensiert, die etwa niedrigere Temperaturen aufweisen als der Halbleiter. Die Dämpfe der Arbeitsflüssigkeit sorgen so für eine effektive Wärmeübertragungsbahn an die wärmeabgebende Fläche des Behälters.

In der US Patentschrift Nr. 3 957 107 wird ein abgedichteter ausdehnbarer Balg gezeigt, der Freon und einen flexiblen Docht für eine Wärmeleitung enthält. Das feste Ende des Balgs ist an einem wärmeableitenden (kalten) Körper befestigt. Das andere bewegliche Ende des Balgs trägt eine thermisch leitende Platte, die bei einer vorgegebenen Temperatur des kalten Körpers mit einer temperaturgeregelten Fläche (z.B. einem Oszillatorkreis) in Berührung tritt.

Im IBM Technical Disclosure Bulletin Nr. 11, Band 17, vom April 1975 wird auf Seite 3313 die Wärmeleitung und der thermische Kontakt zwischen einem Wärmeableiter und einem Halbleitermodul beschrieben. Der Wärmeleitung dient dabei ein längliches, flexibles Balgenrohr.

Im IBM Technical Disclosure Bulletin, Nr. 8, Band 14, Jan. 1972 wird auf Seite 2533 beschrieben, wie eine Druckänderung durch einen Balg kompensiert wird, der ganz in der Flüssigkeit eingetaucht ist. Der Balg hat zum Betrieb eine Öffnung in die umgebende Luft.

Die Aufgabe der vorliegenden Erfindung besteht in der Schaffung einer verbesserten Kapselanordnung zum Kühlen von Halbleiterchips u.ä.

Diese Aufgabe der Erfindung wird in vorteilhafter Weise durch die im kennzeichnenden Teil des Anspruches 1 genannten Maßnahmen gelöst. Weitere Merkmale der Erfindung sind den Unteransprüchen zu entnehmen.

Ausführungsbeispiele der Erfindung sind in dem Zeichnungen dargestellt und werden im folgenden näher beschrieben.

Es zeigen:

Fig. 1 eine Schnittansicht eines Ausführungsbeispieles der Erfindung,

Fig. 1A eine vergrößerte Ansicht eines Teiles der in Fig. 1 gezeigten Struktur,

Fig. 2 eine Schnittansicht eines weiteren Ausführungsbeispiels der Erfindung mit einer Leitflächenstruktur und

Fig. 3 eine Schnittansicht eines anderen Ausführungsbeispiels der Erfindung mit einer Kanalstruktur des Kühlflüssigkeitssystems.

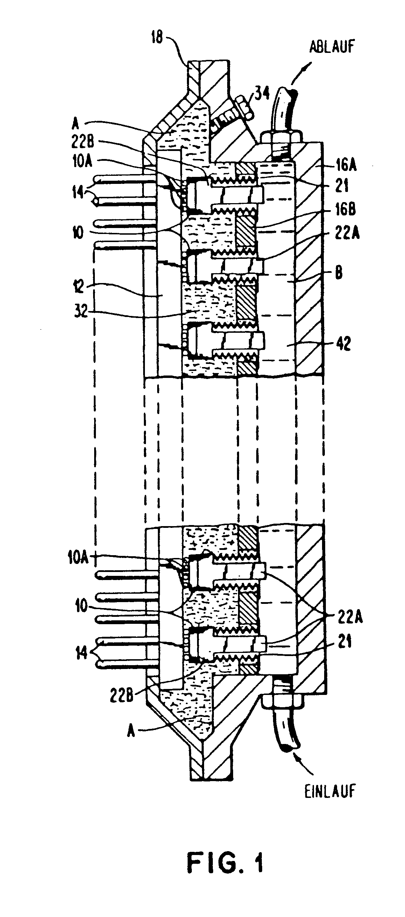

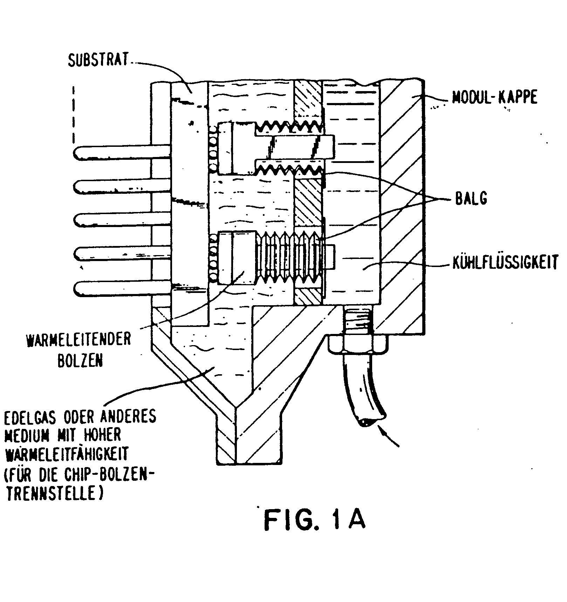

Fig. 1 zeigt eine Schnittansicht durch ein zum Kühlen der in Festkörpertechnik ausgeführten Chips 10. Der in solchen Schaltungschips verbrauchte Strom erzeugt bekanntlich Wärme, die nach außen abgeleitet werden muß. Die verschiedenen Schaltungen auf einem Chip haben unterschiedlichen Stromverbrauch und die in den Schaltungen integrierten Komponenten müssen für einen zuverlässigen Betrieb durch eine angemessene Kühlung auf einer Betriebstemperatur gehalten werden, die in einem entsprechenden Bereich liegt.

Auf einer Seite eines im allgemeinen aus Keramikmaterial bestehenden Substrates 12 sind Chips 10 montiert, deren Anschlußstifte 14 auf der anderen Seite des Substrats liegen. Die integrierten Schaltungen auf den Chips sind in bekannter Technik durch Lötverbindungen 10A mit den nicht dargestellten Leitern im Substrat 12 verbunden. Diese Leiter wiederum sind wahlweise mit den Anschlußstiften 14 verbunden. Die Anschlußstifte 14 dienen dem Einstecken des Moduls in eine Schaltkarte (nicht dargestellt). Eine Modulkappe 16A ist mit einem Flansch 18 verbunden, der vom Rand der Modulkappe 16A zum Substratrand verläuft. Die Modulkappe 16A/16B besteht aus einem Material mit einem hohen Wärmeleitwert wie Kupfer oder Aluminium. Gemäß der Darstellung in Fig. 1 ist für jedes Chip 10 ein federnder, thermisch leitender Balg 21 vorgesehen. Jeder Balg 21 steht in thermischer Verbindung mit einem thermisch leitenden Element bzw. einem wärmeleitenden Bolzen 22A/22B.

In Fig. 1 wird die Ausrichtung der wärmeleitenden Bolzen 22A/22B auf die plane Chipoberfläche durch die Wirkung der federnden Balgen 21 verstärkt. Jede aus dem Balg 21 und dem wärmeleitenden Bolzen 22A/22B bestehende Struktur bildet eine hermetische Abdichtung zwischen den Kammern A und B. Insbesondere weist jeder Balg an der chipnahen Seite zum wärmeleitenden Bolzen 22A/22B oder an der Stelle seiner Verbindung mit der Aussparung in der Modulkappe 16B eine hermetische Dichtung auf. Jede Aussparung in der Modulkappe 16B ist auf eine Chipposition auf dem Substrat 12 ausgerichtet. Jeder Bolzen 22A/22B hat einen ersten Teil 22B mit einer planen Oberfläche, die auf der ihm gegenüberliegenden im wesentlichen ebenfalls planen Oberfläche des zugehörigen Chip aufliegt. Jeder einen wärmeleitenden Bolzen 22A/22B tragende Balg 21 federt genügend, damit ein enger Oberflächenkontakt gewährleistet ist. Durch die Federkraft der Balgen werden die Bolzen 22A/22B auch auf die Chips 10 gedrückt, die von der Oberfläche des Substrates 12 unterschiedlich weit entfernt sind. In dem in Fig. 1 gezeigten Ausführungsbeispiel wird der thermische Widerstand der Schnittfläche zwischen dem wärmeleitenden Bolzen und dem Chip durch den besseren physikalischen Kontakt zwischen den aufeinandergedrückten planen Oberflächen des Bolzens und des Chips reduziert. In Fig. 1 wird ein thermisch leitendes Mittel 32, vorzugsweise Helium durch die Einfüllöffnung 34 in den offenen Raum zwischen dem Substrat 12 und der gegenüberliegenden hermetisch abgedichteten Struktur eingefüllt, die aus der Modulwand 16B, dem Balg 21 und dem Bolzen 22A/22B besteht. Dieser die Schnittflächen zwischen Bolzen und Chip enthaltende Raum ist in Fig. 1 mit dem Zeichen A gekennzeichnet.

Eine physikalische Eigenschaft von Helium ist seine hohe Wärmeleitfähigkeit, die besonders an der Schnittstelle zwischen Bolzen und Chip ausgenutzt wird. Weiterhin ist Helium ein Schutzgas, d.h. es ist elektrisch nicht leitend, es ist nicht giftig, nicht korrodierend, nicht brennbar und nicht explosiv. Dieses Gas hat außerdem eine hohe Haftfähigkeit. Andere Gase mit niedrigem Molekulargewicht wie Wasserstoff oder Kohlendioxid können ebenso verwendet werden. Diese haben jedoch unerwünschte Eigenschaften wie beispielsweise die Explosionsgefahr bei der Verwendung von Wasserstoff.

Der Raum oder das Volumen zwischen der Modulkappe 16A und der hermetisch abgedichteten Struktur, gebildet durch die Modulwand 16B, die Balgstrukturen 21 und die Bolzen 22A/22B ist eine Kammer mit der Bezeichnung B. Diese Kammer hat einen Einlauf und einen Auslauf, durch den ein geeignetes Kühlmittel wie etwa Wasser geführt wird. Der obere Teil 22A eines jeden Bolzen 22A/22B reicht in die Kammer B und somit in das Kühlmittel hinein.

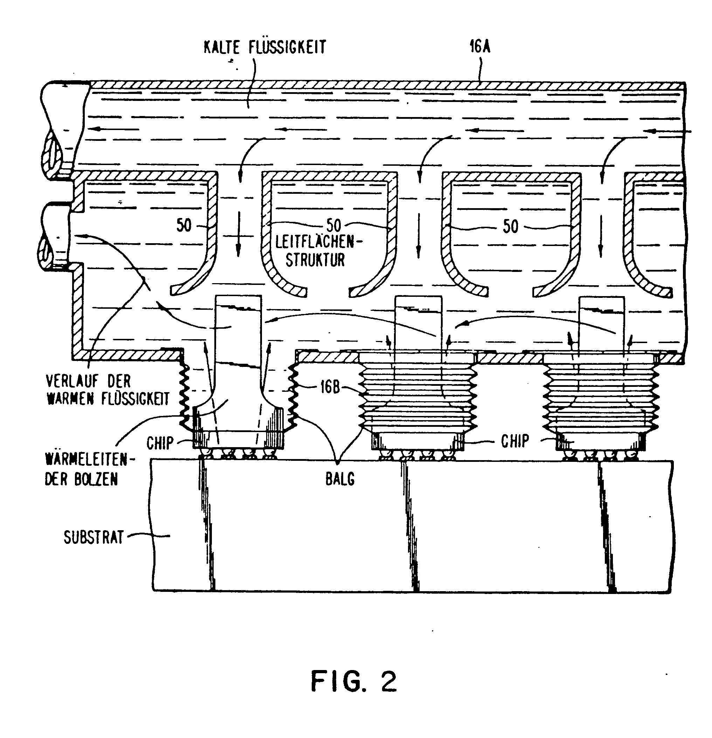

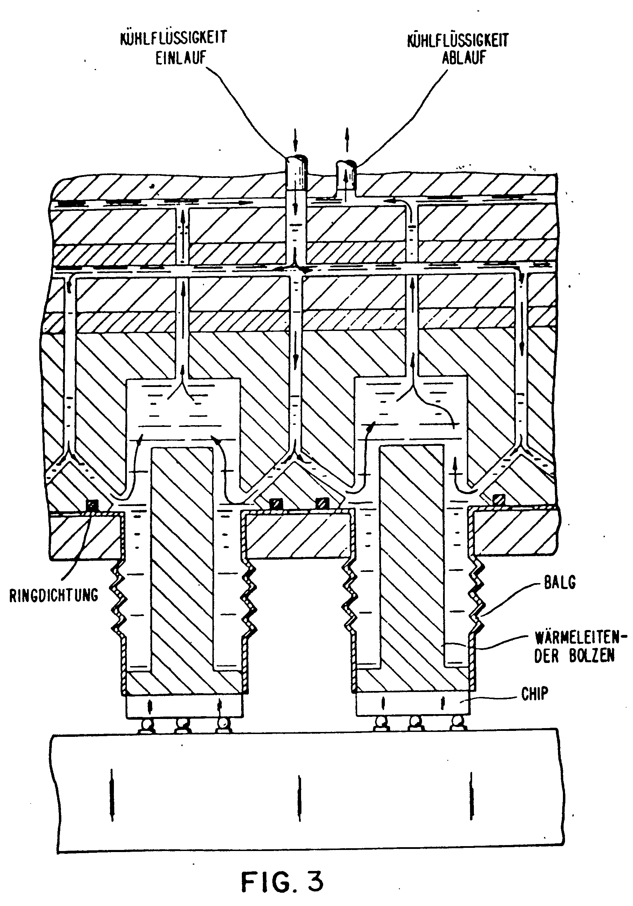

Die Fign. 2 und 3 zeigen ähnliche Ausführungsbeispiele der Erfindung wie die Fig. 1.

In Fig. 2 ist in der Kammer B eine Struktur aus Leitblechen 50 vorgesehen, um das Kühlmittel von einer Kühlmittelvorratskammer direkt auf die aus Balgen und Bolzen bestehende Struktur zu leiten. Somit has das Kühlmittel an den Kühlstellen eine gleichmäßigere Temperatur als in der in Fig. 1 gezeigten Struktur, wo das Kühlmittel nacheinander von einer Kühlstelle zur anderen fließt.

In Fig. 3 wird das Kühlmittel von einer nicht dargestellten Kühlmittelquelle über Kanäle an jeden Kühlbolzen herangeleitet. Das Kühlmittel von jeder Bolzenposition wird in dem in Fig. 3 gezeigten Ausführungsbeispiel über einzelne Kanäle an die Kühlmittelquelle zurückgeführt.

Die Kombination der hohen Wärmeleitfähigkeit von Helium und seiner Fähigkeit zum Ausfüllen von Hohlräumen zusammen mit dem verbesserten physikalischen Kontakt der Kontaktflächen zwischen dem wärmeleitenden Bolzen und dem Chip durch die Balgenstruktur wird in jedem Ausführungsbeispiel der Erfindung dazu genutzt, die thermische Verbindung an der Schnittfläche zwischen Chip und Bolzen und somit die Kühlung des Moduls zu verbessern.

**Patentansprüche**

1. Kapselanordnung zum Kühlen von Halbleiterchips mit einem Wärmeabführelement in engem Kontakt zum Halbleiterchip, mit einem federnden, balgförmigen Element, dessen chipfernes Ende in einer Aussparung eines wärmeleitenden Teiles der Kapselanordnung fixiert ist und mit einem Kühlmedium innerhalb und außerhalb des balgförmigen Elementes, dadurch gekennzeichnet, daß das balgförmige Element (21) an seinem chipfernen Ende zu einem Kühlmediumsystem (42) hin offen ist und daß durch das balgförmige Element (21), welches das Wärmeabführelement (22) ganz oder teilweise enthält, das Kühlmedium außerhalb des balgförmigen Elementes (21) von dem Kühlmedium innerhalb des balgförmigen Elementes (21) voneinander getrennt ist.

2. Anordnung nach Anspruch 1, dadurch gekennzeichnet, daß als Kühlmedium außerhalb des balgförmigen Elementes (21) ein verflüssigtes wärmeleitendes Gas und daß als Kühlmedium innerhalb des balgförmigen Elementes (21) eine Kühlflüssigkeit verwendbar ist.

3. Anordnung nach einem der Ansprüche 1—2, dadurch gekennzeichnet, daß das Kühlmediumsystem (42) Leitflächenstrukturen (50) oder Kanalstrukturen aufweist, durch die das Kühlmedium an dem Wärmeabführelement (22) vorbeiführbar ist.

4. Anordnung nach Anspruch 1, dadurch gekennzeichnet, daß die thermische Kontaktfläche zwischen dem Wärmeabführelement (22) und dem Halbleiterchip (10) plan ist.

5. Anordnung nach Anspruch 1, dadurch gekennzeichnet, daß das Wärmeabführelement (22) Bolzenform aufweist.

6. Anordnung nach Anspruch 2, dadurch gekennzeichnet, daß als wärmeleitendes Gas bzw. als Kühlflüssigkeit verflüssigtes Edelgas, vorzugsweise Helium, verwendbar ist.

7. Anordnung nach einem der Ansprüche 1 bis 6, dadurch gekennzeichnet, daß pro Kapselanordnung mehrere Chips mit jeweils zugeordneten balgförmigem Element (21) vorgesehen sind.

**Claims**

1. An encapsulated cooling module for semiconductor chips with a thermally conductive element in intimate contact with the semiconductor chip, with a resilient, bellows like structure having its end remote from the chip fixed in a recess of a thermally conductive area of the encapsulated module, and with a cooling medium inside and outside the bellows like structure, characterized in that the bellows like structure (21) on its end remote from the chip is open to a cooling medium system (42), and that by means of the bellows like structure (21), partly or wholly containing the thermally conductive element (22), the cooling medium outside the bellows like structure (21) and the cooling medium inside the bellows like structure (21) are separated from each other.

2. The encapsulated module according to claim 1, characterized in that a liquefied thermally conductive gas is used as a cooling medium outside the bellows like structure (21), and that a cooling liquid is used as a cooling medium inside the bellows like structure (21).

3. The encapsulated module according to any one of the claims 1 to 2, characterized in that the cooling medium system (42) has baffle structures (50) or channel structures, by means of which the cooling medium is guided past the thermally conductive element (22).

4. The encapsulated module according to claim 1, characterized in that the thermal interface between the thermally conductive element (22) and the semiconductor chip (10) is planar.

5. The encapsulated module according to claim 1, characterized in that the thermally conductive element (22) is stud-shaped.

6. The encapsulated module according to claim 2, characterized in that liquefied noble gas, preferably helium, is used as a thermally conductive gas or as a cooling liquid.

7. The encapsulated module according to any one of the claims 1 to 6, characterized in that for each encapsulated module a plurality of chips are provided, each of which is associated with a bellows like structure (21).

### Revendications

1. Ensemble de capsules pour le refroidissement de microplaquettes semi-conductrices comportant un élément de transfert de chaleur en contact étroit avec la microplaquette semi-conductrice, un élément élastique formant soufflet dont l'extrémité éloignée de la microplaquette est fixée dans un évidement d'une partie thermiquement conductrice de l'ensemble de capsules, et un milieu de refroidissement situé à l'intérieur et à l'extérieur de l'élément formant soufflet, caractérisé en ce que l'extrémité éloignée de la microplaquette de l'élément formant soufflet (21) s'ouvre sur un système de milieu de refroidissement (42), et en ce que le milieu de refroidissement situé à l'extérieur de l'élément formant soufflet (21) est séparé du milieu de refroidissement situé à l'intérieur de l'élément formant soufflet (21) par l'élément formant soufflet (21) qui contient complètement ou partiellement l'élément de transfert de chaleur (22).

2. Ensemble selon la revendication 1 caractérisé en ce qu'un gaz liquéfié, thermiquement conducteur peut être utilisé comme milieu de refroidissement à l'extérieur de l'élément formant soufflet (21), et qu'un liquide de refroidissement peut être utilisé comme milieu de refroidissement à l'intérieur de l'élément formant soufflet (21).

3. Ensemble selon l'une des revendication 1 et 2, caractérisé en ce que le système de milieu de refroidissement (42) comporte des structures de surfaces conductrices (50) ou des structures de canal qui permettent de faire passer le milieu de refroidissement le long de l'élément de transfert de chaleur (22).

4. Ensemble selon la revendication 1, caractérisé en ce que l'interface de contact thermique entre l'élément de transfert de chaleur (22) et la microplaquette semi-conductrice (10) est plan.

5. Ensemble selon la revendication 1, caractérisé en ce que l'élément de transfert de chaleur (22) a la forme d'un goujon.

6. Ensemble selon la revendication 2, caractérisé en ce que du gaz noble liquéfié, de préférence l'hélium, est utilisé comme gaz thermiquement conducteur ou comme liquide de refroidissement.

7. Ensemble selon l'une quelconque des revendications 1 à 6, caractérisé en ce que chaque ensemble de capsules correspond à plusieurs microplaquettes dont chacune est associée à un élément formant soufflet (21).

**FIG. 1**

SUBSTRAT

MODUL-KAPPE

BALG

KÜHLFLÜSSIGKEIT

WÄRMELEITENDER
BOLZEN

EDELGAS ODER ANDERES
MEDIUM MIT HOHER
WÄRMELEITFÄHIGKEIT
(FÜR DIE CHIP-BOLZEN-
TRENNSTELLE)

**FIG. 1 A**

KALTE FLÜSSIGKEIT     16A

50

50
LEITFLÄCHEN-
STRUKTUR

50

VERLAUF DER
WARMEN FLÜSSIGKEIT

16B

CHIP

WÄRMELEITEN-
DER BOLZEN

BALG

CHIP

SUBSTRAT

FIG. 2

3

KÜHLFLÜSSIGKEIT EINLAUF

KÜHLFLÜSSIGKEIT ABLAUF

RINGDICHTUNG

BALG

WÄRMELEITEN-DER BOLZEN

CHIP

FIG. 3